# EUROPEAN PATENT APPLICATION

(11) **EP 2 650 918 A1**
(43) Date of publication of application: **16.10.2013**
(21) Application number: 12163539.5
(22) Date of filing: 10.04.2012
(51) Int. Cl.: H01L 25/075

(54) **Light emitting module**

(71) Applicant: Koninklijke Philips N.V., 5656 AE Eindhoven (NL)
(72) Inventor: Peeters, Martinus Petrus Joseph, 5600 AE Eindhoven (NL); De Beer, Esther, 5600 AE Eindhoven (NL); Van Kaathoven, Dirk Jan, 5600 AE Eindhoven (NL); Oepts, Wouter, 5600 AE Eindhoven (NL); Gielen, Herman Johannes Gertrudis, 5600 AE Eindhoven (NL)
(74) Representative: Damen, Daniel Martijn

(57) **Abstract**

There is provided a light emitting module (10) for generating light with a white light spectrum having a desired white rendition relating to an improved white appearance of a white obj ect illuminated by the light emitting module (10), the light emitting module (10) comprising at least one primary light emitting diode element (20) arranged to emit white light and at least one secondary light emitting diode element (30) arranged to emit short wavelength blue light. The invention is advantageous in that it provides a light spectrum having excellent white rendition meaning that the white appearance of a white object illuminated by the light emitting module (10) is considerably improved.

## Description

### FIELD OF THE INVENTION

The present invention relates to the field of illumination devices consisting of light emitting diodes. In particular, it relates to a light emitting module comprising a number of light emitting diode elements combined with one or more short wavelength blue light emitting diode elements and to methods for generating light with a light spectrum having a desired white rendition using such a light emitting module.

### BACKGROUND OF THE INVENTION

Light sources or illumination devices consisting of light emitting diodes (LEDs) are today often replacing conventional light sources such as incandescent lamps and fluorescent light sources. In many ways, light emitting diodes have advantages compared to conventional light sources, especially when it comes to light conversion efficiency. However, one disadvantage is that LEDs generate light in a relatively narrow spectral band. In many applications, such as retail applications and environments, the standard is set by light sources such as the Philips CDM-Elite. The CDM-Elite has high quality of light and an excellent white rendition. The white rendition relates to a desired improved white appearance of a white object being illuminated by a light source. When LED-based light sources are used to replace traditional lighting systems, they are especially required to generate light that appears to be "white".

Color reproduction is typically measured using the color rendering index (CRI), which is calculated in Rₐ. The CRI is sometimes also referred to as color rendition index. The CRI is a quantitative measure of the ability of a light source to reproduce the colors of various objects faithfully in comparison with an ideal or natural light source. Daylight has a high CRI, where Rₐ is approximately 100. Incandescent bulbs are relatively close with an Rₐ greater than 95 and fluorescent lighting is less accurate with an Rₐ of typically 70-90.

Consequently, in order to achieve the desired "white" light in LED-based lighting applications, light sources with a high CRI are desirable. For LED lighting systems there are warm-white or neutral-white LED modules with a color rendering of 80 or 90 readily available. Although the color rendition of these sources is good, white objects viewed under these light sources appear somewhat less white compared to the standard conventional alternatives. When viewed under these light sources, white objects appear somewhat colored with a yellowish or brown appearance. In some applications, this may be a disadvantage for these LED modules, especially for the mentioned retail applications where lamps having excellent "white rendition", which is often referred to as "crispy white", are used.

The 1931 CIE Chromaticity Diagram or Color Space Diagram (Commission International de 1'Eclairage) is used to represent aspects relating to the present invention. The term chromaticity is used to identify the color of a light source regardless of its brightness or luminance. In particular, the chromaticity of a light source can be represented by chromaticity coordinates, or color points. The color temperature of a light source is defined in terms of an ideal, purely thermal light source also known as a blackbody radiator, whose light spectrum has the same chromaticity as that of the light source. The color temperature is measured in Kelvin (K). The so called black body locus is the path or *locus* that the color of an incandescent black body would take in a particular chromaticity space as the blackbody temperature changes.

Many attempts have been made relating to improvement of the white light illumination of LED sources. US 2011/0221330 A1 describes LED devices and methods for outputting light perceived as white or near white. In this document it is shown that the presence of an added long wavelength blue peak closes "the cyan gap" in the light spectrum, which improves CRI and thereby enhances color rendering.

However, there is still a need for an efficient solution on how to achieve the desired "white" light having excellent white rendition in LED applications.

### SUMMARY OF THE INVENTION

In view of the above it is desirable to provide a light emitting module which is able to generate a white light spectrum with an improved white rendition.

It is an object of the present invention to overcome or at least mitigate the problems discussed above, and to provide an improved light emitting module in relation to the white rendition aspect. In particular, it is an object of the present invention to provide a light emitting module which generates light having an excellent white rendering, a so called "crispy white" light.

According to a first aspect of the invention, this and other objects are achieved by a light emitting module for generating light with a white light spectrum having a desired white rendition relating to an improved white appearance of a white object illuminated by said light emitting module, said light emitting module comprising at least one primary light emitting diode element arranged to emit white light and at least one secondary light emitting diode element arranged to emit short wavelength blue light.

The present invention is based on the idea that by adding a certain amount of short wavelength blue to the light spectrum, an excellent white rendition can be achieved. There is a possibility of making crispy white by tuning the color point far below the BBL. This will result in a color point outside the ANSI color space. But by adding a short wavelength blue, the final color point will be in the ANSI space, with excellent white rendering. The addition of the short wavelength blue is not meant to increase the CRI, it often leads to a decrease of the CRI, but still generates the desired crispy white effect.

The light generated by the light emitting module may have a color point in the CIE 1931 chromaticity diagram which lies below or slightly below the black body locus.

The light generated by the light emitting module may have a color point in the CIE 1931 chromaticity diagram which lies on the black body locus.

When the color point of the light generated by the light emitting module is tuned at little bit below the black body line (BBL) this further improves the white appearance.

However, the addition of a pure blue channel may result in color mixing problems. To overcome this problem, the at least one secondary light emitting diode element may comprise phosphor.

The at least one primary light emitting diode element may comprise at least one white light emitting diode.

The white light spectrum generated by the light emitting module may have a color rendering index (CRI) of 80 or 90.

The short wavelength blue light may have a peak wavelength between 400 and 440 nm.

The at least one primary light emitting diode element may comprise a remote phosphor module and the at least one secondary light emitting diode element may further be arranged to emit blue light having two different wavelengths. The light of both blue LEDs (short and long wavelength) are converted by the remote phosphor component. The amount of blue light that is converted may depend on the wavelength of the channel.

Optionally, the light emitting module may comprise a mixture of white light emitting diodes, where the first channel is pumped with a short wavelength blue and the second channel may use a long wavelength blue.

Both the short wavelength blue as well as the long wavelength blue may be located inside a mixing chamber.

Another advantageous alternative could be a combination of a blue LED with white phosphor converted LEDs. This is advantageous in that it would also be a way to solve the color over-angle problem. In normal phosphor converted LEDs there is not enough blue under large angles, because of a longer pathway of blue through the phosphor, which leads to increased conversion under large angles. Possible ways of solving this problem for white phosphor converted LEDs can be adding scattering to the phosphor layer (reduced efficiency) or a dichroic filter on top of the phosphor. Additionally, because of the addition of a blue LED to the module, the majority of the blue light emitted by the module will also have a uniform Lambertian emission profile, which in this way is solving the color-over-angle problem. By choosing a short wavelength blue LED, a good white rendering can be achieved as an additional advantage.

The at least one primary light emitting diode element may therefore comprise at least one white phosphor converted light emitting diode, and the at least one secondary light emitting diode element may comprise at least one blue light emitting diode.

In an embodiment a scattering structure may be added to the phosphor layer.

In an embodiment, the at least one primary light emitting diode element may comprise a yellow/green/red phosphor converted blue light emitting diode.

The phosphor layer of the short and long wavelength blue channel may be different in composition and thickness.

The at least one secondary light emitting diode element arranged to emit short wavelength blue may comprise yellow/green/red phosphor.

Part of the blue light of the short wavelength light emitting diode may be converted using a phosphor layer.

Optionally, the light emitting module may further comprise at least one direct red light emitting diode.

In this way the resulting white spectrum consists of two blue peaks, a broad yellow/green emission and a sharp red contribution. The at least one yellow/green/red phosphor converted blue light emitting diode may have a peak wavelength between 440 and 460 nm and the at least one secondary light emitting diode element may be arranged to emit short wavelength blue light having a peak wavelength between 400 and 440 nm.

The at least one primary light emitting diode element and the at least one secondary light emitting diode element may be arranged on a light emitting diode board comprising a yellow/green/red phosphor.

The light emitting diode board may be a chip-on-board.

The yellow/green/red phosphor may be arranged on the light emitting diode board or in a remote configuration.

The blue light emitting diodes may be positioned in a mixing box and the phosphor may be in the exit window.

According to a second aspect of the invention, the above object and other objects are achieved by a method for generating light with a white light spectrum having a desired white rendition relating to an improved white appearance of a white object illuminated by a light emitting module, the method comprising the steps of arranging, in said light emitting module, at least one primary light emitting diode element to emit white light; arranging, in said light emitting module, at least one secondary light emitting diode element to emit short wavelength blue light.

The light emitting module may be a light emitting module according to anyone of the embodiments described above in relation with the first aspect of the invention.

It is noted that the invention relates to all possible combinations of features recited in the claims. Thus, all features and advantages of the first aspect likewise apply to the second aspect and vice versa. Like reference numerals refer to like elements throughout.

### BRIEF DESCRIPTION OF THE DRAWINGS

This and other aspects of the present invention will now be described in more detail, with reference to the appended drawings showing embodiments of the invention.
Fig. 1 illustrates various tested white spectra for a 455 nm blue LED pump wavelength;
Fig. 2 illustrates various tested white spectra for a 445 nm blue LED pump wavelength;
Fig. 3 illustrates variations in color point for one of the combinations from the previous two figures;
Fig. 4 illustrates one white spectrum with an "excellent" white rendering (dashed line) compared with a white spectrum with an average white rendering (solid line);
Fig. 5 illustrates a CIE 1931 chromaticity diagram indicating the black body locus;
Fig. 6 is a schematic illustration of a light emitting module according to the present invention;
Figs. 7a-g are schematic illustrations of different embodiments of a light emitting module according to the present invention; and
Fig. 8 is a schematic illustration of a method according to the present invention.

### DETAILED DESCRIPTION

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiments are provided for thoroughness and completeness, and to fully convey the scope of the invention to the skilled person.

In a study, the inventors have discovered that by adding a certain amount of short wavelength blue to the spectrum, an excellent white rendition can be achieved also for LED modules. To further improve the white appearance the color point of the system may be tuned at little bit below the black body line (BBL).

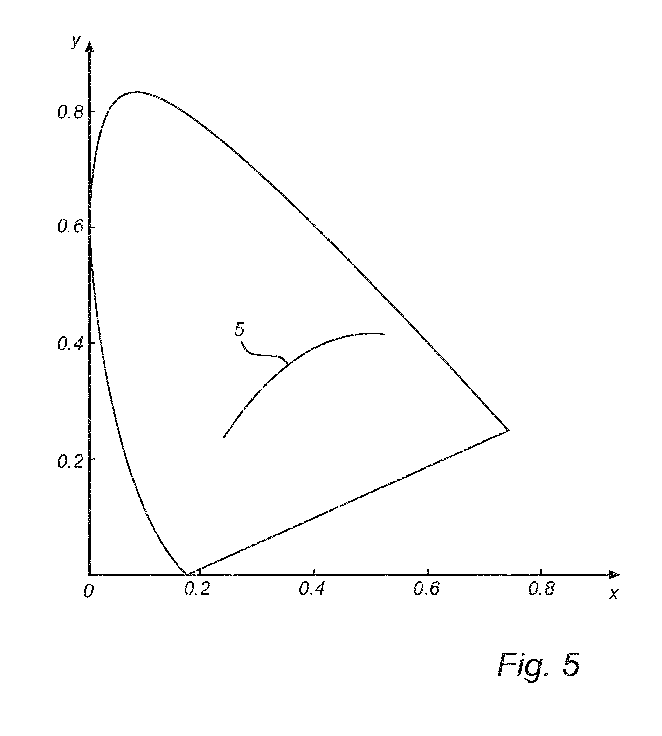

Fig. 5 is a schematic illustration of the CIE 1931 chromaticity diagram indicating the black body locus.

Several white spectra near 3000 K (on the BBL, and slightly off-BBL) were synthesized. The gap between blue and yellow (the cyan gap) was varied by choosing different blue LEDs in combination with different yellow/green/red phosphors. In the study, some hybrid systems were also included where direct red LEDs were used. Additionally, some variation in color point along the BBL and perpendicular to the BBL was also included in the study.

In the study, the white rendering of the white sources was investigated. None of the spectra gave a white rendering that came near that of a conventional high standard light source, such as the earlier mentioned CDM-Elite.

To test the effect on white appearance, different white spectra were made. Two different blue pump wavelengths were used to achieve the same color point.

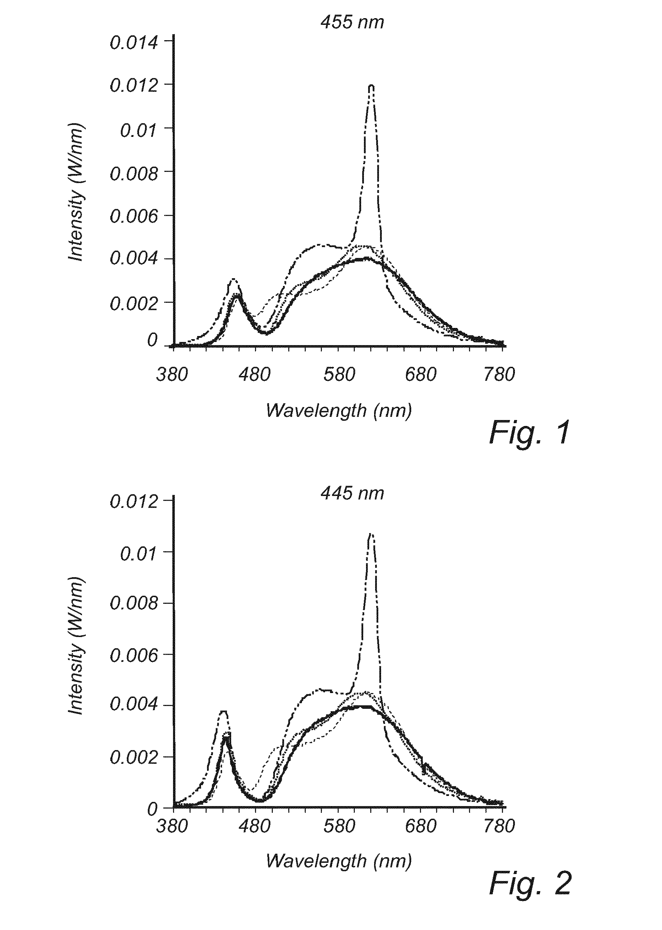

A 455 nm blue pump was used in combination with different selected yellow/green/red phosphors in order to make white light. In Fig. 1 various tested white spectra are shown for these different combinations, where these variations account for the different lines in the graph.

In the same way, a 445 nm blue LED pump was used in combination with different selected yellow/green/red phosphors. In a similar way, Fig. 2 illustrates various white spectra for these corresponding combinations. The different phosphor choices are represented by the different lines in both Fig. 1 and Fig. 2.

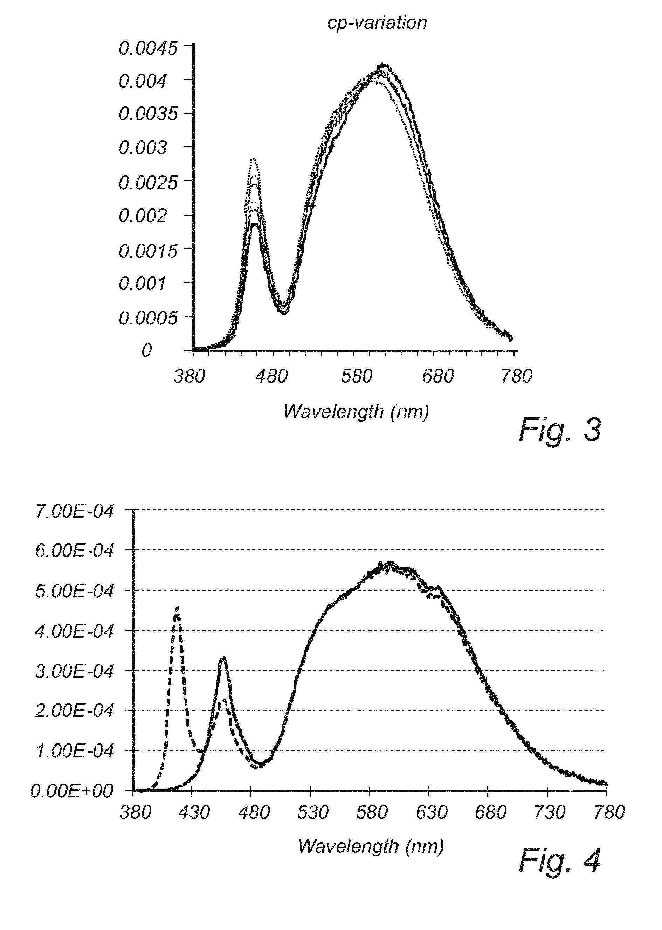

For one of the combinations in the previous two figures, light was generated with a small offset in color point. The color point variation may be along the BBL or perpendicular to the BBL. Fig. 3 illustrates these variations in spectra for one of the combinations.

As already mentioned above, none of these tested spectra gave a white rendering with properties approaching those of a conventional high standard light source.

However, during this study the inventors found that the addition of some short wavelength blue to the spectrum leads to the desired excellent white rendition (crispy white).Fig. 4 illustrates one white spectrum with an "excellent" white rendering (dashed line) compared with a white spectrum with an average white rendering (solid line).

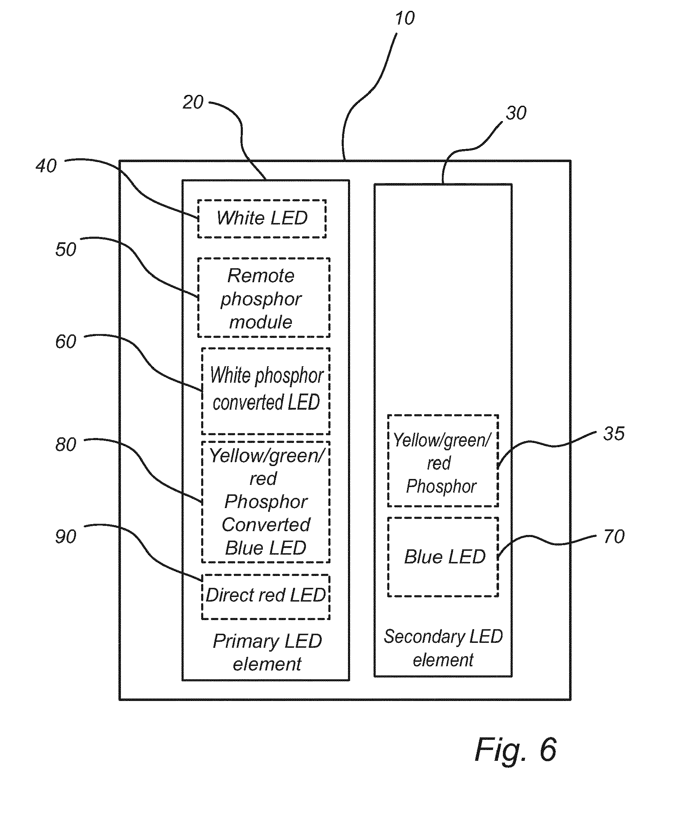

Fig. 6 is a principal schematic illustration of a light emitting module 10 according to the present invention. The light emitting module 10 comprises a primary light emitting diode (LED) element 20. The primary LED element 20 is arranged to emit white light. The light emitting module 10 also comprises a secondary LED element 30, which is arranged to emit short wavelength blue light.

The secondary LED element may comprise a yellow/green/red phosphor 35.

The primary LED element 20 may comprise at least one white light emitting diode 40.

The white light spectrum emitted by the light emitting module 10 may have a color rendering index of 80 or 90.

The short wavelength blue light emitted by the secondary LED element 30 may have a peak wavelength between 400 and 440 nm.

The primary LED element 20 may comprise a remote phosphor module 50 and the secondary LED element 30 may further be arranged to emit blue light having two different wavelengths.

In one embodiment, the primary LED element 20 may comprise at least one white phosphor converted light emitting diode 60 and the secondary LED element 30 may comprise at least one blue light emitting diode 70.

Optionally, the light emitting module may have a scattering structure added to the phosphor layer.

In another embodiment, the primary LED element 20 comprises at least one yellow/green/red phosphor 85 converted blue LED 80.

Optionally, the secondary LED element 30 arranged to emit short wavelength blue light may comprise a yellow/green/red phosphor 35.

The composition and/or thickness of the phosphors 35 and 85 on the different blue LEDs may be different.

In an embodiment, the light emitting module 10 may comprise at least one direct red LED 90. In this case the phosphor converted blue channel will not contain sufficient red, and will have a color point far above the BBL.

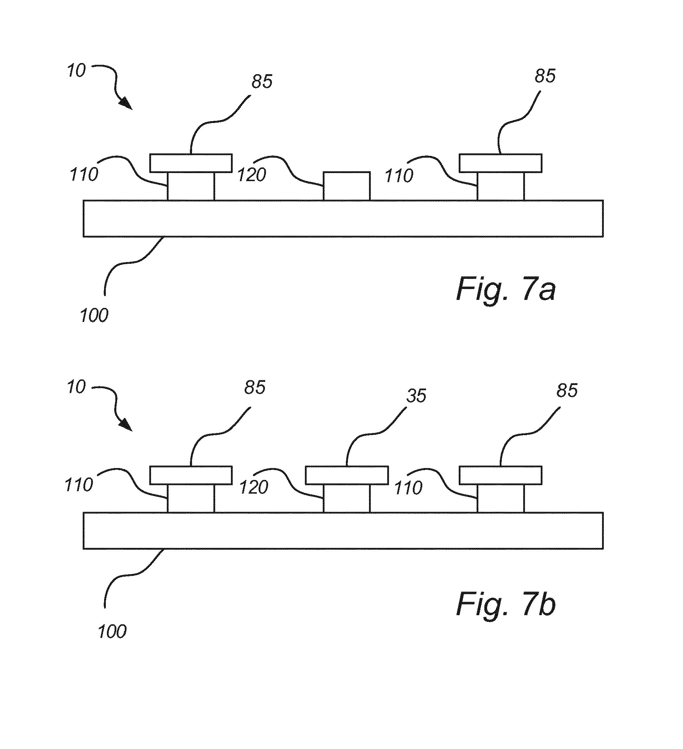

Many different embodiments are possible for realizing the present invention and will now be described in relation with figs. 7a-7g.

Fig. 7a illustrates an embodiment of a light emitting module 10 according to the present invention. The light emitting module 10 comprises an LED board 100 where two blue light emitting diodes 110 are arranged. The two blue light emitting diodes 110 are arranged to emit blue light having a peak wavelength between 440 and 460 nm. The two blue light emitting diodes 110 comprise a yellow/green/red phosphor 85. The light emitting module 10 also comprises a light emitting diode 120 arranged to emit short wavelength blue light having a peak wavelength between 400 and 440 nm.

Fig. 7b illustrates another embodiment of a light emitting module 10 according to the present invention. In this embodiment, the light emitting diode 120 arranged to emit short wavelength blue light also comprises a yellow/green/red phosphor 35.

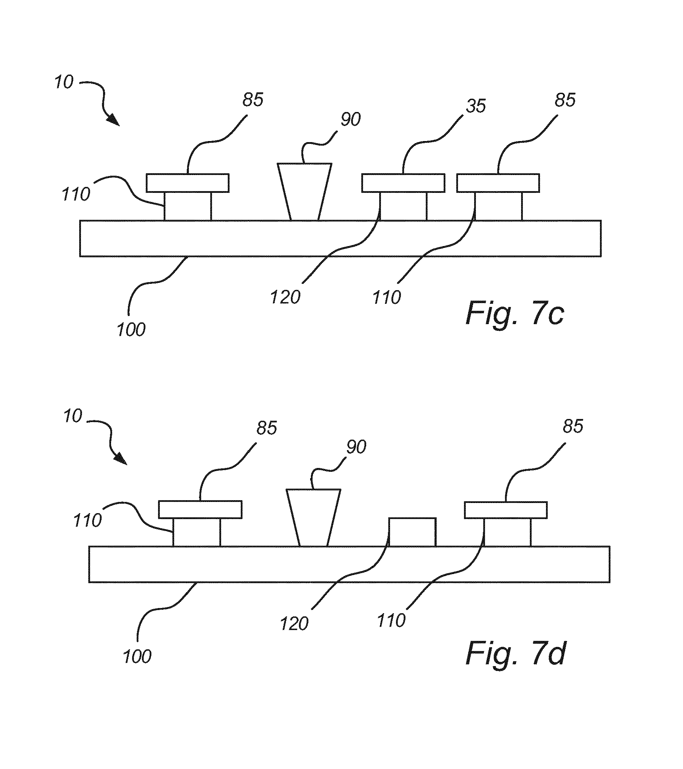

In another embodiment shown in Fig. 7c, the light emitting module 10 is similar to the embodiment shown in Fig. 7b but comprises an optional direct red light emitting diode 90. The direct red light emitting diode 90 may have a wavelength > 600 nm.

Fig. 7d shows yet another embodiment according to the present invention. Here, the two blue light emitting diodes 110 arranged to emit blue light having a peak wavelength between 440 and 460 nm comprise a yellow/green/red phosphor 85. In this embodiment, the light emitting diode 120 arranged to emit short wavelength blue light does not comprise any phosphor.

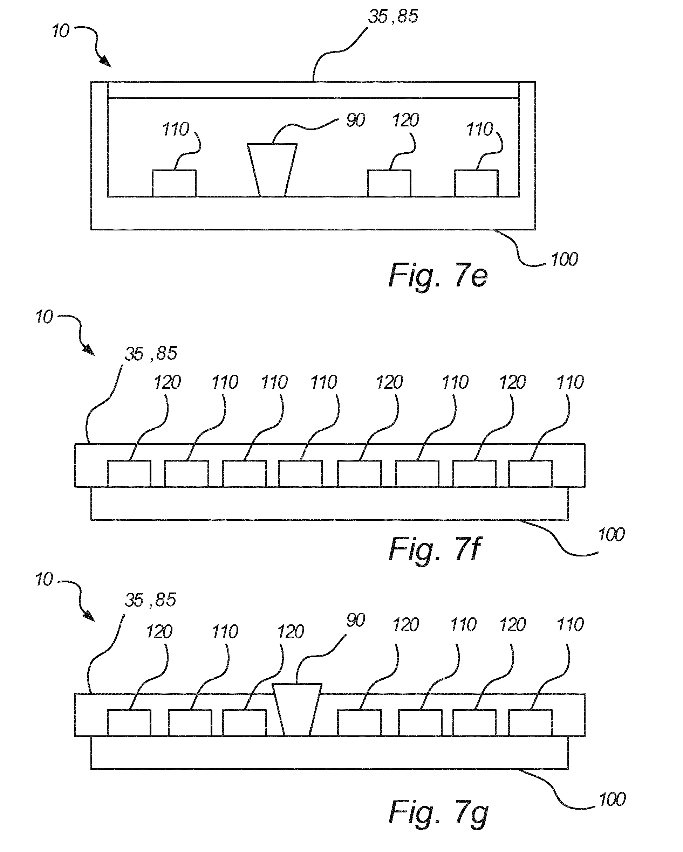

Fig. 7e illustrates an embodiment of a light emitting module 10 according to the present invention. In this embodiment, the light emitting module 10 comprises two light emitting diodes 110 which are arranged to emit blue light having a peak wavelength between 440 and 460 nm. The light emitting module also comprises a light emitting diode 120 arranged to emit short wavelength blue light having a peak wavelength between 400 and 440 nm and a direct red light emitting diode 90. In this embodiment, the light emitting module 10 is a remote phosphor module. The yellow/green/red phosphor 35,85 is applied in a remote configuration.

Fig. 7f illustrates another embodiment of a light emitting module 10 comprising a LED board 100 where a number of light emitting diodes 110 are arranged closely together with a number of light emitting diodes 120. The LED board 100 of the light emitting module 10 comprises a yellow/green/red phosphor 35,85 directly applied onto it.

Fig. 7g shows yet another embodiment similar to the embodiment shown in Fig. 7f, comprising an optional direct red light emitting diode 90.

The LED board 100 can be a chip-on-board in both Fig. 7f and Fig. 7g.

It is to be noted that the composition and/or thickness of the phosphor 35,85 may be different for the different LEDs in the above described embodiments.

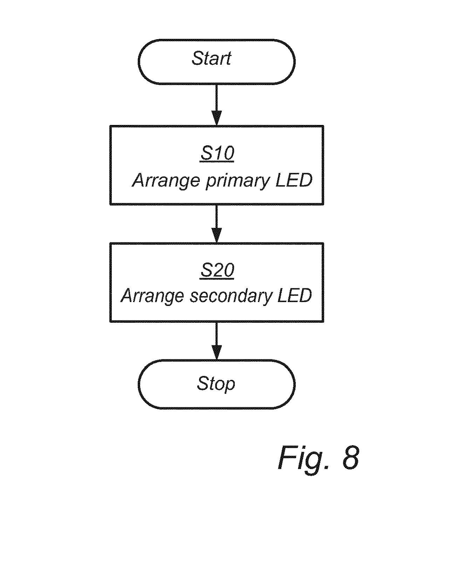

Fig. 8 is a schematic illustration of a method according to the present invention. The method generates light with a white light spectrum having a desired white rendition relating to an improved white appearance of a white object illuminated by a light emitting module 10, illustrated in Fig. 6. The method comprises a step S10 where at least one primary light emitting diode element 20 is arranged in the light emitting module 10. In a step S20 at least one secondary light emitting diode element 30 is arranged in the light emitting module 10.

It is to be noted that the light emitting module 10 can be arranged according to any one of the above described embodiments.

It is to be noted that all the above described embodiments and aspects of the present invention are based on the idea of adding short wavelength blue light to the light spectrum in order to obtain excellent white rendering and thereby generating the so desired "crispy white" light.

The person skilled in the art realizes that the present invention by no means is limited to the preferred embodiments described above. On the contrary, many modifications and variations are possible within the scope of the appended claims.

Additionally, variations to the disclosed embodiments can be understood and effected by the skilled person in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

## Claims

1. A light emitting module (10) for generating light with a white light spectrum having a desired white rendition relating to an improved white appearance of a white object illuminated by said light emitting module (10), said light emitting module (10) comprising
at least one primary light emitting diode element (20) arranged to emit white light and
at least one secondary light emitting diode element (30) arranged to emit short wavelength blue light.

2. The light emitting module (10) according to claim 1, wherein said at least one secondary light emitting diode element (30) comprises phosphor.

3. The light emitting module (10) according to anyone of claims 1 to 2, wherein said generated light has a color point in the CIE 1931 chromaticity diagram which lies within the ANSI color space.

4. The light emitting module (10) according to anyone of claims 1 to 3, wherein said generated light has a color point in the CIE 1931 chromaticity diagram which lies below the black body locus (5).

5. The light emitting module (10) according to anyone of claims 1 to 4, wherein said at least one primary light emitting diode element (20) comprises at least one white light emitting diode (40).

6. The light emitting module (10) according to anyone of claims 1 to 6, wherein said short wavelength blue light has a peak wavelength between 400 and 440 nm.

7. The light emitting module (10) according to claim 1, wherein said at least one primary light emitting diode element (20) comprises a remote phosphor module (50) and said at least one secondary light emitting diode element (30) is further arranged to emit blue light having two different wavelengths.

8. The light emitting module (10) according to claim 1, wherein said at least one primary light emitting diode element (20) comprises at least one white phosphor converted light emitting diode (60) and said at least one secondary light emitting diode element (30) comprises at least one blue light emitting diode (70).

9. The light emitting module (10) according to claim 1, wherein said at least one primary light emitting diode element comprises at least one yellow/green/red phosphor converted blue light emitting diode (80).

10. The light emitting module (10) according to claim 9, wherein said at least one secondary light emitting diode element (30) arranged to emit short wavelength blue light comprises yellow/green/red phosphor (35).

11. The light emitting module (10) according to anyone of claims 9 to 10, further comprising at least one direct red light emitting diode (90).

12. The light emitting module (10) according to anyone of claims 9 to 11, wherein said at least one yellow/green/phosphor converted blue light emitting diode (80) has a peak wavelength between 440 and 460 nm and said at least one secondary light emitting diode element (30) is arranged to emit short wavelength blue light having a peak wavelength between 400 and 440 nm.

13. The light emitting module (10) according to anyone of claims 9 to 12, wherein said at least one primary light emitting diode element (20) and said at least one secondary light emitting diode element (30) are arranged on a light emitting diode board (100) comprising a yellow/green/red phosphor (35,85).

14. A method for generating light with a white light spectrum having a desired white rendition relating to an improved white appearance of a white object illuminated by a light emitting module (10), said method comprising the steps of
arranging (S10), in said light emitting module (10), at least one primary light emitting diode element (20) to emit white light,
arranging (S20), in said light emitting module (10), at least one secondary light emitting diode element (30) to emit short wavelength blue light.

15. The method according to claim 14, wherein said light emitting module (10) is a light emitting module (10) according to anyone of claims 1 to 13.
